# EUROPÄISCHE PATENTSCHRIFT

(11) **EP 2 144 363 B1**
(45) Veröffentlichungstag und Bekanntmachung des Hinweises auf die Patenterteilung: **02.05.2012**
(21) Anmeldenummer: 09008657.0
(22) Anmeldetag: 02.07.2009
(51) Int. Cl.: H03B 11/02, H01T 9/00

(54) **Mikrowellengenerator**
Microwave generator
Générateur de micro-ondes

(30) Priorität: 07.07.2008 DE 102008031625
(43) Veröffentlichungstag der Anmeldung: 13.01.2010
(73) Patentinhaber: Diehl BGT Defence GmbH & Co.KG, 88662 Überlingen (DE)
(72) Erfinder: Stark, Robert, 91438 Bad Winsheim (DE); Urban, Jürgen, 91056 Erlangen (DE)
(74) Vertreter: Diehl Patentabteilung

(56) Entgegenhaltungen:
- WO-A1-2006/008000
- DE-A1-102005 013 925
- US-A- 3 351 806

## Beschreibung

Die Erfindung betrifft einen Mikrowellengenerator gemäß dem Oberbegriff der nebengeordneten Ansprüche 1 bis 3. Ein solcher Mikrowellengenerator ist aus der WO2006/008000 A1 bekannt.

Aus der DE 10 2005 002 279 A1 ist ein Mikrowellengenerator mit zwei in einem Gehäuse vorgesehenen und über eine bei Anliegen einer Hochspannung zur Abstrahlung von Mikrowellen durchschlagenden Funkenstrecke getrennten Elektroden bekannt, wobei die eine, äußere Elektrode topfartig ausgebildet ist und die andere innere Elektrode zumindest über einen Teil ihrer Länge außenseitig beabstandet übergreift. Die topfartige, äußere Elektrode weist einen Bodenabschnitt auf, der gleichzeitig den seitlichen Abschluss des Gehäuses bildet. Die innere Elektrode ist kappen- bzw. halbkugelförmig gerundet und die Außenelektrode weist einen kleinen kugelkappenförmigen Vorsprung auf, wobei sich die beiden Elektroden am Vorsprung mit einem geringen Abstand von z. B. wenigen mm gegenüber liegen.

Ferner ist aus der DE 10 2005 044 353 A1 ein Mikrowellengenerator der eingangs genannten Art mit einer einzigen Funkenstrecke bekannt, die als Ringfunkenstrecke ausgebildet ist; ebenfalls ist aus der DE 10 2005 013 925 A1 ein Mikrowellengenerator mit einer einzigen Funkenstreke bekannt, die mit einer Pitz formigen Elektrode ausgebildet ist.

Alle diese bekannten Mikrowellengeneratoren weisen einen DS (Damped Sinusoid)-Resonator auf, welcher aus einer koaxialen Kapazität besteht, die über eine einzige Funkenstrecke, das heißt eine Funkenstreckeneinrichtung mit einer einzigen Funkenstrecke, entladen wird. Diese Kapazität bildet mit den physikalischen Eigenschaften des Schalterplasmas in der Funkenstrecke sowie im Zusammenhang mit der elektrischen Verschaltung einen Schwingkreis, der aus einem ohmschen Widerstand R, einer Induktivität L und einer Kapazität C besteht. Die Kapazität wird über eine Ladeimpedanz R, L auf Spannungen bis in den 100kV- bis MV-Bereich aufgeladen. Die zunehmende Ladespannung führt schließlich - dem Paschengesetz folgend - zum Durchbruch der Funkenstrecke. Der Durchbruch der Funkenstrecke kann auch gezielt durch einen geeigneten Triggermechanismus herbeigeführt werden.

Schon seit je her zielt die Entwicklung von HPEM DS Hochleistungsmikrowellenquellen darauf ab, mit der sogenannten DS-Technologie (Damped Sinusoid = gedämpfte Sinusschwingung) einen breitbandigen Mikrowellenpuls zu erzeugen und diesen in die Umgebung ungerichtet oder auch gerichtet abzustrahlen. Der abgestrahlte Mikrowellenpuls hat dabei typischerweise eine Bandbreite von etwa 20 % der sogenannten Mittenfrequenz beim Leistungsmaximum und überdeckt damit, abhängig von der mittleren Abstrahlfrequenz einen gewissen Bereich im Frequenzspektrum. Aus elektromagnetischen Einkopplungsuntersuchungen (EME) mit potentiellen Targetsystemen lässt sich erkennen, dass im Frequenzbereich zwischen einigen 10 MHz bis in den GHz-Bereich die Targetsysteme eine besonders hohe Empfindlichkeit aufweisen. Es wäre daher wünschenswert, um ein möglichst breites Zielspektrum von unterschiedlichen Targetsystemen zu überdecken, diesen Frequenzbereich mit möglichst wenigen HPEM-Wirksystemen abzudecken. Die oben beschriebenen herkömmlichen Mikrowellengeneratoren sind in der Lage, einen Frequenzbereich von ca. 50 Mhz bis ca. 450 Mhz (jeweils Mittenfrequenzen) abzudecken, so dass derzeit in etwa ein effektiver Frequenzbereich von ca. 40 Mhz (tiefste Frequenzen) bis etwa 600 Mhz (höchste Frequenzen) unter Verwendung unterschiedlicher HPEM-DS-Wirksysteme abgedeckt werden kann. Die bisher bekannten Mikrowellenquellen sind jedoch nicht in der Lage, auch Targetsysteme mit Einkopplungsfrequenzen von mehr als 600 Mhz zu stören. So lässt sich zwar der Bereich niedrigerer Frequenzen, das heißt unter 40 Mhz, relativ einfach optimieren, in dem die Pulslänge des Systems vergrößert wird oder durch geschickte Überlagerung und Reflexion der Pulse im pulsformenden Netzwerk variiert wird (so genanntes "pulse forming"), bei den höheren Frequenzen über 600 Mhz sind jedoch bei der derzeit vorhandenen Quellenarchitektur insbesondere die physikalischen Eigenschaften des Schalterplasmas ein limitierender Faktor, der das Generieren von Frequenzen über 600 Mhz verhindert.

Es ist daher Aufgabe der vorliegenden Erfindung, einen Mikrowellengenerator zu schaffen, der bei einfachem Aufbau in der Lage ist, einen breitbandigen Mikrowellenpuls hoher Energiedichte auch in einem Bereich höherer Frequenzen, insbesondere über 600 Mhz, zu erzeugen.

Diese Aufgabe wird erfindungsgemäß durch einen Mikrowellengenerator gemäß einem der nebengeordneten Ansprüche 1 bis 3 gelöst. Bevorzugte Aus- bzw. Weiterbildungen des erfindungsgemäßen Mikrowellengenerators sind in den Unteransprüchen wiedergegeben.

Der Erfindung liegt die Überlegung zugrunde, dass die physikalischen Eigenschaften der Funkenstrecke, wie z. B. die Durchbruchspannung, der Umgebungsdruck, der Abstand zwischen den Funkenstrecken-Elektroden, die Plasmaimpedanz usw., maßgeblich das Schalt- d. h. Zündverhalten der Funkenstrecken-Entladung bestimmen und damit die Anstiegszeit und die Pulsform bzw. die unterschiedlichen Frequenzanteile des generierten Hochspannungspulses bestimmen.

Nach dem Durchschalten der Funkenstrecke (SG = Spark Gap) wird die im Resonator-Schwingkreis gespeicherte Energie ganz oder teilweise über eine mit dem Resonator gekoppelte Abstrahleinrichtung, z. B. in Form einer Antenne, in die Umgebung des Mikrowellengenerators abgestrahlt.

Die Entkopplung des Schwingkreises vom Hochspannungsgenerator, bei dem es sich beispielsweise um einen Marx-Generator handelt, erfolgt durch in den Ladekreis eingebrachte Impedanzen in Form von ohmschen oder induktiven Widerständen. Die Größe der in die Umgebung abgestrahlten Energie ist maßgeblich durch die Impedanzanpassung des Schwingkreises an die Umgebung, das heißt den umgebenden Raum, bestimmt. Die Impedanz des freien Raums, die sogenannte Free Space Condition Impedanz ZFreeSp, beträgt 377 Ω.

Bei einer idealen Anpassung des Mikrowellengenerators an diese Impedanz des freien Raums würde die gesamte Energie in Form eines Rechteckimpulses abgestrahlt werden. Bei einer leichten Fehlanpassung wird ein Teil der Energie bzw. des Pulses an einem Impedanzsprung reflektiert und führt somit in Zusammenhang mit der Überlagerung von auslaufender und rücklaufender Welle zu einer Veränderung der abgestrahlten Pulsform. Durch entsprechende Anpassung des Impedanzverhältnisses ist somit eine Pulsformung des abgestrahlten Pulses erzielbar, die einer gedämpften Sinus-Schwingung gleicht.

Bei einer extremen Fehlanpassung verhält sich das System wie ein Schwingkreis hoher Güte, so dass kaum Energie in die Umgebung abgestrahlt wird. Die Energie bleibt im System und führt zu einem resonanten Schwingverhalten, bis die Energie durch die Eigenverluste des Schwingkreises verbraucht ist.

Die Anzahl der Schwingungen, das heißt die Güte des Schwingkreises pro Puls, kann durch Anpassung des Impedanzsprungs verändert werden. Angestrebt ist bei einem Mikrowellengenerator ein erzeugter Hochspannungspuls, das heißt ein Elektromagnetischer Puls, der mindestens einen Schwingungszyklus bis einige 10 Schwingungszyklen durchläuft.

Vor dem Hintergrund der oben wiedergegebenen Überlegungen kommt die Erfindung zu dem Schluss, dass für die durch ein HPEM-DS-System abgestrahlten Frequenzen die Form des im DS-Resonator erzeugten Hochspannungspulses bzw. des zeitlichen Verlaufes des abgestrahlten elektromagnetischen Pulses maßgeblich ist. Zerlegt man nämlich die durch den HPEM-DS-Resonator erzeugte Pulsform mittels einer Fouriertransformation in ihre Frequenzanteile, so ist zu erkennen, dass die niederfrequenten Anteile des Pulses vor allem durch die Pulsdauer bzw. die Schwingungsperiode des Pulses repräsentiert werden, während die Pulsanstiegszeit und die Pulsabfallzeit vor allem die hochfrequenten Anteile des abgestrahlten elektromagnetischen Pulses bestimmen. Dies führt letztlich zu der Erkenntnis, dass schnellere Pulsanstiegs- und Abfallzeiten eine Verstärkung des höherfrequenten Anteils des Pulses im Frequenzspektrum bewirken können. Durch Verkürzung der Pulsanstiegszeit kann damit der Frequenzanteil des Pulses zu höheren Frequenzen verschoben werden.

Bei den in HPM-DS-Systemen verwendeten Resonatoren handelt es sich um ein pulsformendes Netzwerk (PFN), das aus einer oder mehreren Kapazitäten in koaxialer Geometrie besteht. Jede Kapazität ist dabei mit einer Funkenstrecke (= Spark Gap) als "schließender Schalter" verbunden, der die entsprechende Kapazität bei Schließen des Schalters entlädt. Für Multi-Puls- und Burst-Anwendungen ist die Verschaltung der Kapazitäten so gewählt, dass diese sequenziell entladen werden. Die Anstiegszeit und Pulsform des im Resonator erzeugten Hochspannungspulses und damit der abgestrahlte Frequenzbereich des Systems hängt maßgeblich von der Systemimpedanz sowie dem externen Entladekreis bzw. der externen Beschaltung ab. Die koaxiale Kapazität wird mittels Funkenüberschlag kurzgeschlossen. Die Kapazität bzw. die Kapazitäten bildet bzw. bilden zusammen mit dem Spark Gap (Impedanz des Spark Gaps), der integrierten Abstrahleinheit sowie der Impedanz der Umgebung einen Schwingkreis. Die Anstiegszeit des im DS-Resonator erzeugten Hochspannungspulses wird maßgeblich durch die plasmaphysikalischen Eigenschaften des Spark Gaps (Plasmaimpedanz) bestimmt. Die Eigeninduktivität des Schalterplasmas bestimmt dabei die maximal erzielbare Stromanstiegsrate (Pulsanstiegszeit) und damit den hochfrequenten Anteil in der erzeugten Pulsform.

Um die Limitierung bei der Verkürzung der Pulsanstiegszeit durch die Eigeninduktivität einer Funkenstrecke zu durchbrechen, werden erfindungsgemäß mehrere Funkenstrecken parallel geschaltet. Dies geschieht vorzugsweise in der schon bekannten koaxialen DS-Resonator-Geometrie. Durch die gleichzeitige bzw. simultane Zündung von N Funkenstrecken verteilt sich der Entladestrom auf N Plasmakanäle. Da sich in einer Parallelschaltung von mehreren Induktivitäten die Gesamtinduktivität des Systems verhält wie der Kehrwert der Summe der reziproken Werte der Einzelsysteme, verringert sich die Induktivität des Gesamtsystems im Idealfall umgekehrt proportional zur Anzahl der gleichzeitig betriebenen Funkenstrecken.

Die Verringerung der Plasmainduktivität durch Parallelschaltung mehrerer Funkenstrecken verringert damit die Anstiegszeit des im DS-Resonator erzeugten Hochspannungspulses. Dies wiederum resultiert in einer Erhöhung der hochfrequenten Anteile in der abgestrahlten Pulsform.

Die Anordnung der mindestens zwei Funkenstrecken in Parallelschaltung kann dabei in geordneter geometrischer Form, linear, koaxial, symmetrisch oder auch willkürlich verteilt zwischen den beiden Resonator-Elektroden erfolgen. Eine willkürliche Verteilung der Funkenstrecken zwischen den beiden Resonator-Elektroden kann soweit erfolgen, solange die Funktionalität des Resonators dadurch nicht beeinträchtigt wird. Es können sowohl identische als auch unterschiedliche Geometrien der Elektroden in den einzelnen Funkenstrecken realisiert werden. Für die oben beschriebene Funktionsweise der parallel geschalteten Funkenstrecken ist es besonders vorteilhaft, wenn folgende Vorraussetzungen erfüllt sind:
1. Der Abstand der Funkenstrecken-Elektroden der einzelnen parallel geschalteten Funkenstrecken ist gleich, oder zumindest hinreichend gleich, so dass die Zündbedingung nach Townsend, entsprechend dem Paschengesetz, für alle Funkenstrecken erfüllt ist und sich die Entladung auf die unterschiedlichen Funkenstrecken innerhalb eines für die Anwendung akzeptablen Jitters verteilt.
2. Der von der Energieversorgung des Systems bereitgestellte Hochspannungspuls ist ausreichend schnell und niederinduktiv an den Resonator angekoppelt. Der DS-Resonator ist hinreichend niederinduktiv aufgebaut, damit die Anstiegszeit des Hochspannungspulses an den einzelnen Multi-Channel-Funkenstrecken hinreichend schnell ist, so dass die statistischen Zündprozesse an den Multi-Channel-Funkenstrecken-Elektroden, die den zeitlichen Aufbaumechanismus des Plasmakanals (Entladekanal zwischen den Funkenstrecken-Elektroden) bestimmen, gegeneinander zu vernachlässigen sind und damit in einem entsprechend kurzen, für diese Anwendung hinreichenden Zeitbereich, ein gleichzeitiges Zünden der Funkenstrecken gewährleistet wird. Die Anstiegszeit des insgesamt durch die Entladung der Kapazität in den umgebenden Raum abgestrahlten Pulses wird dann maßgeblich durch den zeitlichen Jitter der einzelnen Entladungen (Spark Gaps) untereinander und die Induktivität der Spark Gap Plasmen bestimmt.

Durch die nahezu gleichzeitige (ein gewisser zeitlicher Jitter, bedingt durch statistische Prozesse im Plasma, wird immer gegeben sein) Zündung der N Funkenstrecken wird die Entladung und damit der Entladestrom des Resonators auf mehrere, nämlich N Plasmakanäle verteilt. Durch die Parallelschaltung der Plasmaentladungen addieren sich die Plasmainduktivitäten der einzelnen Funkenstrecken reziprok, so dass die Gesamtinduktivität der Entladung in erster Näherung umgekehrt proportional mit der Anzahl der zur Verfügung stehenden Funkenstrecken sinkt. Der Betrieb von mehreren Funkenstrecken in paralleler Schaltung ermöglicht es also, die Induktivität des Gesamtsystems zu reduzieren. Durch die Reduktion der Plasmainduktivität sinkt damit die Anstiegszeit des im DS-Resonator erzeugten Hochspannungspulses, was wiederum zur Folge hat, dass sich der Frequenzanteil des erzeugten DS-Pulses zu höheren Frequenzen verschiebt, die dann über die in den Resonator integrierte und entsprechend dem Frequenzbereich angepasste Abstrahleinheit (Antenne) in die Umgebung abgestrahlt werden.

Ein weiterer Aspekt der vorliegenden Erfindung ist es auch, dass sich gleichzeitig mit der Parallelschaltung mehrerer Plasmakanäle auch die Gesamtverlustleistung (ohmsche Anteile) in den Funkenstrecken reduziert, was zu einer Erhöhung der Effizienz des DS-Resonatorsystems beiträgt. Zusätzlich werden gegenüber einem Einzel-Funkenstrecken-System durch die geringere Belastung (geringere Stromdichte auf der Elektrodenoberfläche) die Erosionsmechanismen auf den Elektrodenoberflächen reduziert und damit deren Lebensdauer erhöht.

Weitere Merkmale, Einzelheiten und Vorteile der Erfindung ergeben sich aus der nachfolgenden Beschreibung von in den Figuren dargestellten Ausbildungen des erfindungsgemäßen Mikrowellengenerators.

Es zeigen:
- Figur 1: eine schematische Darstellung des erfindungsgemäßen Mikrowellengenerators,
- Figur 2: Schnittansichten einer ersten Ausführungsform des erfindungsgemäßen Mikrowellengenerators,
- Figur 3: eine perspektivische Ansicht der ersten Ausführungsform des Mikrowellengenerators, wie sie in Figur 2 dargestellt ist,
- Figur 4: Schnittansichten einer zweiten Ausführungsform des erfindungsgemäßen Mikrowellengenerators,
- Figur 5: Schnittansichten einer dritten Ausführungsform des erfindungsgemäßen Mikrowellengenerators, und
- Figur 6: Schnittansichten einer vierten Ausführungsform des erfindungsgemäßen Mikrowellengenerators.

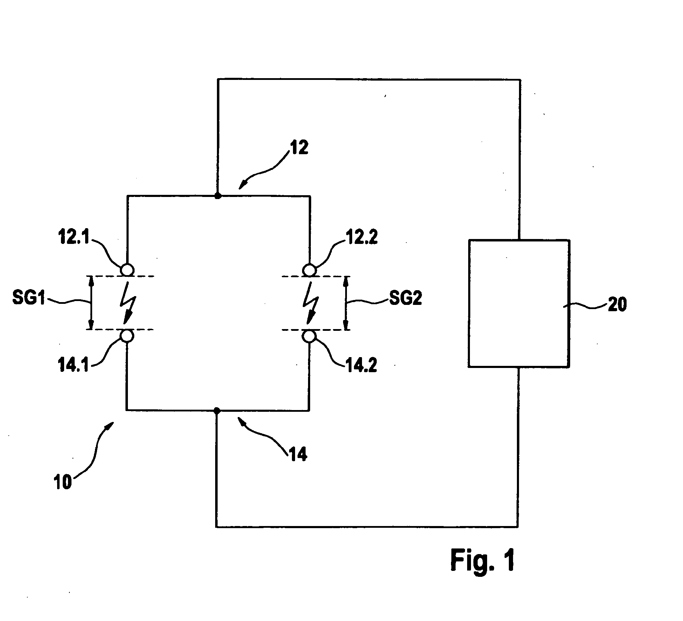

Figur 1 zeigt in schematischer Darstellung einen erfindungsgemäßen Mikrowellengenerator. Dieser Mikrowellengenerator umfasst einen Resonator, der zwei voneinander beabstandete Resonator-Elektroden 12, 14 aufweist. Zwischen den beiden Resonator-Elektroden 12, 14 kann mittels der Energieversorgung 20 eine Spannung generiert werden. Wenn die zwischen den Resonator-Elektroden 12, 14 anliegende Spannung bis zur Zündspannung erhöht ist, erfolgt ein Durchschlag der Spannung zwischen den Resonator-Elektroden 12, 14 durch die Funkenstreckeneinrichtung 10. Dabei weist erfindungsgemäß die Funkenstreckeneinrichtung 10 mindestens zwei parallel geschaltete Funkenstrecken SG1, SG2 auf. Dabei bildet sich die Funkenstrecke SG1 zwischen einer vorbestimmten Stelle 12.1 der einen Resonator-Elektrode 12 und einer vorbestimmten Stelle 14.1 der anderen Resonator-Elektrode 14 aus. Entsprechendes gilt für die zweite Funkenstrecke SG2 und alle eventuell weiter vorhandenen Funkenstrecken SGn.

Durch die Parallelschaltung der mehreren Funkenstrecken SGn bzw. durch deren simultanes Durchschlagen verteilt sich der Entladestrom auf n Plasmakanäle. Da sich in einer Parallelschaltung von mehreren Induktivitäten die Gesamtinduktivität des Systems wie der Kehrwert der Summe der reziproken Werte der Einzelsysteme verhält, verringert sich die Induktivität des Gesamtsystems umgekehrt proportional zur Anzahl der gleichzeitig betriebenen Funkenstrecken SGn. Die Verringerung der Plasmainduktivität durch Parallelschaltung mehrerer Funkenstrecken SGn verringert damit die Anstiegszeit des im DS-Resonator erzeugten Hochspannungspulses, was wiederum in einer Erhöhung der hochfrequenten Anteile in der abgestrahlten Pulsform resultiert.

Vorzugsweise ist die Beabstandung der Resonator-Elektroden 12, 14 im Bereich der Ausbildung einer jeden der Funkenstrecken SGn auf einen im Wesentlichen gleichen, kleineren Abstand verringert. Das bedeutet zum einen, dass die Länge der Funkenstrecken SG1 und SG2 gleich ist, zum anderen, dass der Abstand der Resonator-Elektroden 12, 14 voneinander im Bereich der Ausbildung der Funkenstrecken SGN minimal ist. Diese Merkmalskombination hat den Vorteil, dass dadurch die Anzahl der Plasmakanäle zwischen den Resonator-Elektroden 12, 14 beim Durchschlagen der Funkenstreckeneinrichtung 10 nach Erreichen der Zündspannung exakt vorbestimmt werden kann, da der Durchschlag bevorzugt an den Stellen mit minimalem Abstand zwischen den Elektroden erfolgt. Dadurch, dass die Länge aller Funkenstrecken gleich groß ist, kann erreicht werden, dass alle Funkenstrecken gleichzeitig durchschlagen.

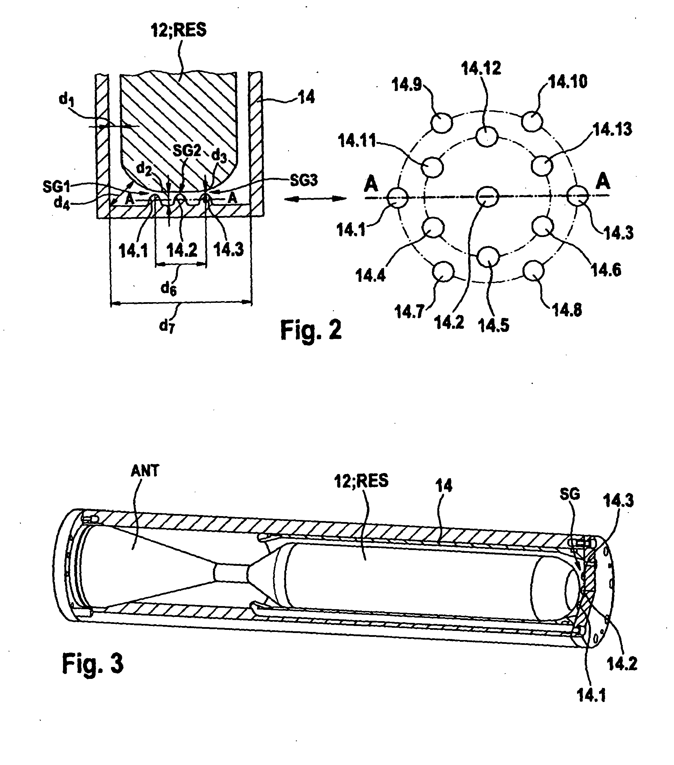

Figur 2 zeigt eine erste Ausführungsform des erfindungsgemäßen Mikrowellengenerators in zwei Schnittansichten. Figur 3 zeigt die gleiche Ausführungsform in perspektivischer Ansicht.

Wie den Darstellungen in Figur 2 und 3 zu entnehmen ist, weist der Mikrowellengenerator gemäß erster Ausführungsform einen Resonator mit koaxialem Aufbau auf. Dabei weist der Resonator eine im Wesentlichen zylindermantelförmige Innenelektrode 12 und eine die Innenelektrode umgreifende Außenelektrode 14 auf. Die Innenelektrode 12 ist am unteren Ende geschlossen. Dieses geschlossene Ende der Innenelektrode 12 liegt einer die Außenelektrode 14 abschließenden Stirnfläche gegenüber. Die Außenelektrode 14 weist Ausbuchtungen 14.1, 14.2, 14.3 in Richtung der Innenelektrode 12 auf, so dass der Abstand d₃ zwischen den Elektroden im Bereich der Ausbuchtungen 14.1, 14.2, 14.3 kleiner ist als jeder Abstand d₁, d₂, d₄ zwischen den Elektroden außerhalb des Bereichs der Ausbuchtungen. Dabei sind die Abstände d₃ zwischen den Elektroden 12, 14 im Bereich der Ausbuchtungen 14.1, 14.2, 14.3 untereinander im Wesentlichen gleich. Im Allgemeinen sind d₁, d₂ und d₄ frei wählbar und es gilt: d1, d2, d4 > d3. Gemäß einem Spezialfall kann folgendes gelten: d1 = d2 = d4 > d3 und d7 >= d6 > 0.

Der rechte Teil der Figur 2 zeigt eine mögliche Anordnung der Ausbuchtungen 14.n auf der abschließenden Stirnfläche der Außenelektrode 14. In diesem speziellen Fall handelt es sich um 13 Ausbuchtungen. Es sind aber auch mehr oder weniger Ausbuchtungen möglich, auch in einer anderen, beispielsweise auch nichtsymmetrischen Anordnung.

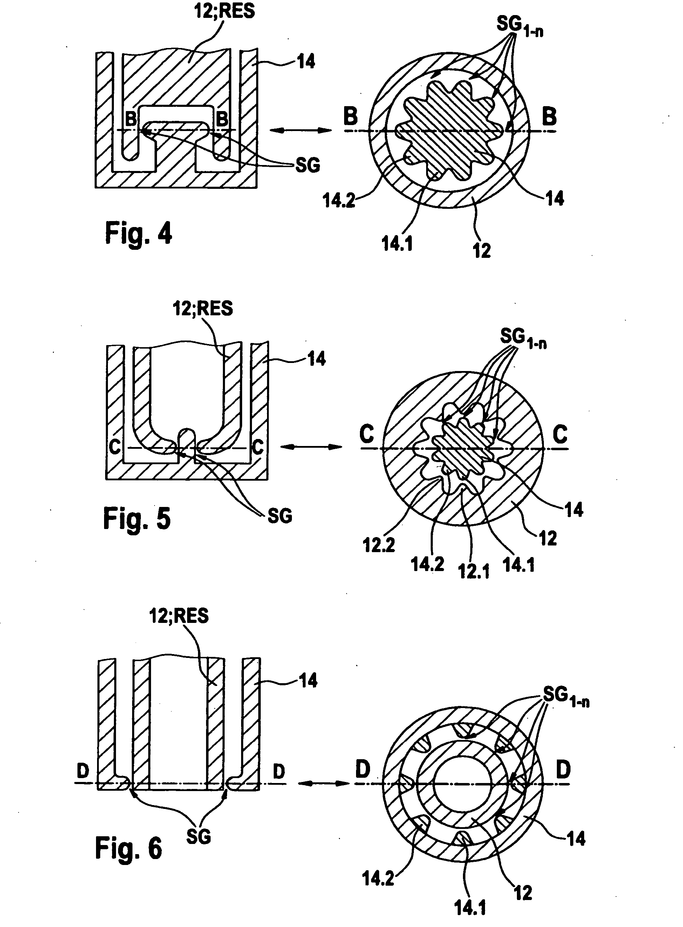

Die perspektivische Darstellung in Figur 3 gilt auch für die nachfolgend beschriebenen Ausführungsformen der Figuren 4, 5 und 6.

Figur 4 zeigt eine zweite Ausführungsform des erfindungsgemäßen Mikrowellengenerators in zwei Schnittansichten. Hier liegt das eine Ende der Innenelektrode 12 einer die Außenelektrode 14 abschließenden Stirnfläche gegenüber. Von dieser Stirnfläche der Außenelektrode 14 ragt ein pilzförmiger Stift koaxial in das Innere der Innenelektrode 12 hinein. Dabei weist der pilzförmige Stift zumindest an seiner breitesten Stelle eine wellenförmige Querschnittsfläche auf. Dadurch werden in diesem Bereich Rippen 14.1, 14.2, 14.n gebildet, die der zylindrischen Innenwandung der Innenelektrode 12 gegenüberstehen. Die durch die Rippen 14.n gebildeten Funkenstrecken SGn sind alle gleich groß.

Der Vorteil der zweiten Ausführungsform besteht zum einen im relativ homogenen Feld zwischen den Rippen 14.n und der zylindrischen Innenwandung der Innenelektrode 12. Zum anderen ist diese Ausführungsform deshalb vorteilhaft, da sie eine nachträgliche Anpassungsmöglichkeit eines konventionellen Mikrowellengenerators darstellt. So kann z. B. der pilzförmige Stift nachträglich von unten in die abschließende Stirnfläche der Außenelektrode 14 eingeschraubt werden, um einen konventionellen Mikrowellengenerator in einen erfindungsgemäßen Mikrowellengenerator umzurüsten.

Eine dritte Ausführungsform des erfindungsgemäßen Mikrowellengenerators ist in Figur 5 in zwei Schnittansichten dargestellt. Auch hier liegt das eine Ende der Innenelektrode 12 einer die Außenelektrode 14 abschließenden Stirnfläche gegenüber. Von der Stirnfläche der Außenelektrode 14 ragt ein Stift mit Rippen 14.1, 14.2, 14.n und Kerben koaxial in das Innere der Innenelektrode 12 hinein. Der Stift weist also eine wellenförmige Querschnittsfläche auf. Zusätzlich weist das Ende der Innenelektrode 12 auch noch Ausbuchtungen 12.1, 12.2, 12.n in Richtung des Stiftes auf, welche den Rippen des Stiftes gegenüber liegen.

Zwar ist die dritte Ausführungsform etwas kritischer als die zweite Ausführungsform, was die Homogenität des elektrischen Feldes in den Spark Gaps SGn anbelangt, jedoch lassen sich bei präziser Ausrichtung der Rippen 14.n und 12.n zueinander räumlich sehr genau begrenzte Plasmakanäle realisieren, welche in vorteilhafter Weise genauer vordefinierbare Eigenschaften, wie z. B. Entladestrom und Plasmainduktivität aufweisen.

Figur 6 zeigt eine vierte Ausführungsform des erfindungsgemäßen Mikrowellengenerators in zwei Schnittzeichnungen. Hier weist die Außenelektrode 14 an einem Ende nockenförmige Ausbuchtungen 14.1, 14.2, 14.n in Richtung der zylinderförmigen Innenelektrode 12 auf. Die zylinderförmige Innenelektrode 12 weist dabei selbst keine Ausbuchtungen auf.

Diese vierte Ausführungsform vereint die Vorteile der zweiten und dritten Ausführungsform miteinander, denn hier ist das elektrische Feld in den Funkenstrecken SGn aufgrund der schwächer gekrümmten Außenfläche der Innenelektrode 12 noch homogen genug, gleichzeitig ist aber die Ausbildung der Funkenstrecken SGn auf einen ausreichend kleinen räumlichen Bereich beschränkt aufgrund der jeweils konvex voneinander wegweisenden Flächen der Nocken 14.n und der zylindrischen Außenfläche der Innenelektrode 12.

Es sei betont, dass die Figuren 2 bis 6 lediglich eine kleine Auswahl möglicher Spark Gap Konfigurationen darstellen, die die geforderten Randbedingungen erfüllen. Darüber hinaus sind auch noch viele andere geometrische Anordnungen vorstellbar. Generell ist es vorteilhaft, bei der Auslegung der Spark Gap Konfigurationen darauf zu achten, dass der minimale Elektrodenabstand in den individuellen Funkenstrecken derart dimensioniert ist, dass zum gewünschten Zeitpunkt (Schaltzeitpunkt), und bei Anliegen der entsprechenden Schaltspannung beim Schaltvorgang die Zündbedingung nach dem Paschengesetz für jede einzelne Funkenstrecke erfüllt ist und damit ein hinreichen genaues zeitliches, also gleichzeitiges, Zünden der Funkenstrecken gewährleistet ist. Zum anderen ist vorteilhafterweise darauf zu achten, dass die Aufladung des Resonators und damit das Aufladen der Funkenstrecken-Elektroden hinreichend schnell geschieht, so dass zusammen mit der Erfüllung der Zündbedingung ein zeitlich synchroner Entladungsaufbau in den individuellen Spark Gaps stattfindet. Durch das gleichzeitige, parallele Zünden der Funkenstrecken reduziert sich die Gesamtimpedanz der Funkenstrecken, wodurch sich ein schnellerer Pulsanstieg realisieren lässt, was letztlich zu einer Erhöhung des abgestrahlten Frequenzspektrums im Bereich höherer Frequenzen führt.

## Patentansprüche

1. Mikrowellengenerator mit einem Resonator, der zwei voneinander beabstandete (d₂) Resonator-Elektroden (12, 14) aufweist, die eine bei Anliegen einer zwischen ihnen anliegenden Zündspannung durchschlagende Funkenstreckeneinrichtung (10) ausbilden,
wobei die Funkenstreckeneinrichtung (10) mindestens zwei parallel geschaltete Funkenstrecken (SG1, SG2, ..., SGn) aufweist,
wobei der Resonator einen koaxialen Aufbau mit einer im Wesentlichen zylindermantelförmigen Innenelektrode (12) und mit einer die Innenelektrode umgreifenden Außenelektrode (14) aufweist,
wobei die Innenelektrode (12) und/oder die Außenelektrode (14) Ausbuchtungen (12.1, 12.2, ..., 12.n; 14.1, 14.2, ..., 14.n) in Richtung der jeweils anderen Elektrode aufweisen, so dass die Abstände (d₃) zwischen den Elektroden im Bereich der Ausbuchtungen kleiner sind als jeder Abstand (d₁, d₂, d₄) zwischen den Elektroden außerhalb des Bereichs der Ausbuchtungen, und wobei die Abstände (d₃) zwischen den Elektroden im Bereich der Ausbuchtungen untereinander im wesentlichen gleich sind,
**dadurch gekennzeichnet,**
**dass** das eine Ende der Innenelektrode (12) einer die Außenelektrode (14) abschließenden Stirnfläche gegenüberliegt, wobei von der Stirnfläche der Außenelektrode (14) ein pilzförmiger Stift koaxial in das Innere der Innenelektrode (12) hineinragt, und wobei der pilzförmige Stift zumindest an seiner breitesten Stelle eine wellenförmige oder sternförmige Querschnittsfläche aufweist.

2. Mikrowellengenerator mit einem Resonator, der zwei voneinander beabstandete (d₂) Resonator-Elektroden (12, 14) aufweist, die eine bei Anliegen einer zwischen ihnen anliegenden Zündspannung durchschlagende Funkenstreckeneinrichtung (10) ausbilden,
wobei die Funkenstreckeneinrichtung (10) mindestens zwei parallel geschaltete Funkenstrecken (SG1, SG2, ..., SGn) aufweist,
wobei der Resonator einen koaxialen Aufbau mit einer im Wesentlichen zylindermantelförmigen Innenelektrode (12) und mit einer die Innenelektrode umgreifenden Außenelektrode (14) aufweist,
wobei die Innenelektrode (12) und/oder die Außenelektrode (14) Ausbuchtungen (12.1, 12.2, ..., 12.n; 14.1, 14.2, ..., 14.n) in Richtung der jeweils anderen Elektrode aufweisen, so dass die Abstände (d₃) zwischen den Elektroden im Bereich der Ausbuchtungen kleiner sind als jeder Abstand (d₁, d₂, d₄) zwischen den Elektroden außerhalb des Bereichs der Ausbuchtungen, und wobei die Abstände (d₃) zwischen den Elektroden im Bereich der Ausbuchtungen untereinander im wesentlichen gleich sind,
**dadurch gekennzeichnet,**
**dass** das eine Ende der Innenelektrode (12) einer die Außenelektrode (14) abschließenden Stirnfläche gegenüberliegt, wobei von der Stirnfläche der Außenelektrode (14) ein Stift mit Rippen (14.1, 14.2, ..., 14.n) und Kerben koaxial in das Innere der Innenelektrode (12) hineinragt, wobei der Stift eine wellenförmige oder sternförmige Querschnittsfläche aufweist, und wobei dieses eine Ende der Innenelektrode (12) Ausbuchtungen (12.1, 12.2, ..., 12.n) in Richtung des Stiftes aufweist, welche den Rippen des Stiftes gegenüber liegen.

3. Mikrowellengenerator mit einem Resonator, der zwei voneinander beabstandete (d₂) Resonator-Elektroden (12, 14) aufweist, die eine bei Anliegen einer zwischen ihnen anliegenden Zündspannung durchschlagende Funkenstreckeneinrichtung (10) ausbilden,
wobei die Funkenstreckeneinrichtung (10) mindestens zwei parallel geschaltete Funkenstrecken (SG1, SG2, ..., SGn) aufweist,
wobei der Resonator einen koaxialen Aufbau mit einer im Wesentlichen zylindermantelförmigen Innenelektrode (12) und mit einer die Innenelektrode umgreifenden Außenelektrode (14) aufweist,
wobei die Innenelektrode (12) und/oder die Außenelektrode (14) Ausbuchtungen (12.1, 12.2, ..., 12.n; 14.1, 14.2, ..., 14.n) in Richtung der jeweils anderen Elektrode aufweisen, so dass die Abstände (d₃) zwischen den Elektroden im Bereich der Ausbuchtungen kleiner sind als jeder Abstand (d₁, d₂, d₄) zwischen den Elektroden außerhalb des Bereichs der Ausbuchtungen, und wobei die Abstände (d₃) zwischen den Elektroden im Bereich der Ausbuchtungen untereinander im wesentlichen gleich sind,
**dadurch gekennzeichnet,**
**dass** die Außenelektrode (14) an einem Ende nockenförmige Ausbuchtungen (14.1, 14.2, ..., 14.n) in Richtung der zylinderförmigen Innenelektrode (12) ohne Ausbuchtungen aufweist.

4. Mikrowellengenerator nach einem der Ansprüche 1 bis 3,
wobei die Beabstandung (d₂) der Resonator-Elektroden (12, 14) im Bereich der Ausbildung einer jeden der Funkenstrecken (SG1, SG2, ..., SGn) auf einen im Wesentlichen gleichen, kleineren Abstand (d₃) verringert ist.

5. Mikrowellengenerator nach Anspruch 4,
wobei die Innenelektrode (12) an einem Ende geschlossen ist und dieses geschlossene Ende der Innenelektrode einer die Außenelektrode (14) abschließenden Stirnfläche gegenüberliegt, und wobei die Ausbuchtungen (12.1, 12.2, ..., 12.n; 14.1, 14.2, ..., 14.n) im Bereich des geschlossenen Endes der Innenelektrode und/oder im Bereich der die Außenfläche abschließenden Stirnfläche angeordnet sind.

6. Mikrowellengenerator nach einem der Ansprüche 1 bis 5,
wobei der von der Energieversorgung (20) bereitgestellte Hochspannungspuls niederinduktiv an den Resonator angekoppelt ist.

7. Mikrowellengenerator nach Anspruch 6,
wobei die Energieversorgung (20) ein Marx Generator, ein Tesla Transformator, ein Piezo-Generator, oder ein Flux Compression Generator, FCG, mit Electro Explosive Opening Switch, EEOS, ist.

## Claims

1. Microwave generator having a resonator which has two resonator electrodes (12, 14), which are at a distance (d₂) from one another, and form a spark gap device (10) which flashes over when a trigger voltage is applied between them,
wherein the spark gap device (10) has at least two parallel-connected spark gaps (SG1, SG2, ..., SGn), wherein the resonator has a coaxial structure having an inner electrode (12), which is essentially in the form of a cylindrical casing, and an outer electrode (14) which surrounds the inner electrode,
wherein the inner electrode (12) and/or the outer electrode (14) have/has outward bulges (12.1, 12.2, ..., 12.n; 14.1, 14.2, ..., 14.n) in the direction of the respective other electrode, such that the distances (d₃) between the electrodes in the area of the outward bulges are less than that distance (d₁, d₂, d₄) between the electrodes outside the area of the outward bulges, and wherein the distances (d₃) between the electrodes in the area of the outward bulges are essentially the same as one another,
**characterized**
**in that** one end of the inner electrode (12) is opposite an end surface which closes the outer electrode (14), wherein a mushroom-shaped pin projects coaxially from the end surface of the outer electrode (14) into the interior of the inner electrode (12), and wherein the mushroom-shaped pin has a cross-sectional area in the form of a wave or a star, at least at its broadest point.

2. Microwave generator having a resonator which has two resonator electrodes (12, 14), which are at a distance (d₂) from one another, and form a spark gap device (10) which flashes over when a trigger voltage is applied between them,
wherein the spark gap device (10) has at least two parallel-connected spark gaps (SG1, SG2, ..., SGn), wherein the resonator has a coaxial structure having an inner electrode (12), which is essentially in the form of a cylindrical casing, and an outer electrode (14) which surrounds the inner electrode,
wherein the inner electrode (12) and/or the outer electrode (14) have/has outward bulges (12.1, 12.2, ..., 12.n; 14.1, 14.2, ..., 14.n) in the direction of the respective other electrode, such that the distances (d₃) between the electrodes in the area of the outward bulges are less than that distance (d₁, d₂, d₄) between the electrodes outside the area of the outward bulges, and wherein the distances (d₃) between the electrodes in the area of the outward bulges are essentially the same as one another,
**characterized**
**in that** one end of the inner electrode (12) is opposite an end surface which closes the outer electrode (14), wherein a pin having ribs (14.1, 14.2, ..., 14.n) and notches project from the end surface of the outer electrode (14) coaxially into the interior of the inner electrode (12), wherein the pin has a cross-sectional area in the form of a wave or a star, and wherein this end of the inner electrode (12) has outward bulges (12.1, 12.2, ..., 12.n) in the direction of the pin, which outward bulges (12.1, 12.2, ..., 12.n) are opposite the ribs on the pin.

3. Microwave generator having a resonator which has two resonator electrodes (12, 14), which are at a distance (d₂) from one another, and form a spark gap device (10) which flashes over when a trigger voltage is applied between them,
wherein the spark gap device (10) has at least two parallel-connected spark gaps (SG1, SG2, ..., SGn), wherein the resonator has a coaxial structure having an inner electrode (12), which is essentially in the form of a cylindrical casing, and an outer electrode (14) which surrounds the inner electrode,
wherein the inner electrode (12) and/or the outer electrode (14) have/has outward bulges (12.1, 12.2, ..., 12.n; 14.1, 14.2, ..., 14.n) in the direction of the respective other electrode, such that the distances (d₃) between the electrodes in the area of the outward bulges are less than that distance (d₁, d₂, d₄) between the electrodes outside the area of the outward bulges, and wherein the distances (d₃) between the electrodes in the area of the outward bulges are essentially the same as one another,
**characterized**
**in that** the outer electrode (14) has outward bulges (14.1, 14.2, ..., 14.n) in the form of studs at one end, in the direction of the cylindrical inner electrode (12) without outward bulges.

4. Microwave generator according to one of Claims 1 to 3,
wherein the distance (d₂) between the resonator electrodes (12, 14) in the area of the formation of each of the spark gaps (SG1, SG2, ..., SGn) is reduced to a shorter distance (d₃), which is essentially the same.

5. Microwave generator according to Claim 4,
wherein the inner electrode (12) is closed at one end and this closed end of the inner electrode is opposite an end surface which closes the outer electrode (14), and wherein the outward bulges (12.1, 12.2, ..., 12.n; 14.1, 14.2, ..., 14.n) are arranged in the area of the closed end of the inner electrode and/or in the area of the end surface which closes the outer surface.

6. Microwave generator according to one of Claims 1 to 5,
wherein the high-voltage pulse which is produced by the power supply (20) is coupled with low inductance to the resonator.

7. Microwave generator according to Claim 6,
wherein the power supply (20) is a Marx generator, a Tesla transformer, a piezo-generator or a flux compression generator, FCG, with an electro-explosive opening switch, EEOS.

## Revendications

1. Générateur de micro-ondes comprenant un résonateur qui présente deux électrodes de résonateur (12, 14) espacées (d₂) l'une de l'autre, lesquelles forment un dispositif éclateur (10) à claquage lors de l'application d'une tension d'amorçage appliquée entre elles,
le dispositif éclateur (10) présentant au moins deux distances de décharge (SG1, SG2, ..., SGn) branchées en parallèle,
le résonateur présentant une structure coaxiale avec une électrode intérieure (12) essentiellement en forme d'enveloppe cylindrique et une électrode extérieure (14) qui entoure l'électrode intérieure,
l'électrode intérieure (12) et/ou l'électrode extérieure (14) présentant des renflements (12.1, 12.2, ..., 12.n ; 14.1, 14.2, ..., 14.n) en direction de l'autre électrode respective, de sorte que les écarts (d₃) entre les électrodes dans la zone des renflements soient inférieurs à chaque écart (d₁, d₂, d₄) entre les électrodes en-dehors de la zone des renflements, et les écarts (d₃) entre les électrodes les unes par rapport aux autres dans la zone des renflements étant essentiellement égaux,
**caractérisé en ce que** l'une des extrémités de l'électrode intérieure (12) est à l'opposé d'une surface frontale qui termine l'électrode extérieure (14), une broche en forme de champignon faisant saillie de manière coaxiale dans l'intérieur de l'électrode intérieure (12) depuis la face frontale de l'électrode extérieure (14), et la broche en forme de champignon présentant une surface en section transversale de forme ondulée ou en forme d'étoile au moins en son endroit le plus large.

2. Générateur de micro-ondes comprenant un résonateur qui présente deux électrodes de résonateur (12, 14) espacées (d₂) l'une de l'autre, lesquelles forment un dispositif éclateur (10) à claquage lors de l'application d'une tension d'amorçage appliquée entre elles,
le dispositif éclateur (10) présentant au moins deux distances de décharge (SG1, SG2, ..., SGn) branchées en parallèle,
le résonateur présentant une structure coaxiale avec une électrode intérieure (12) essentiellement en forme d'enveloppe cylindrique et une électrode extérieure (14) qui entoure l'électrode intérieure,
l'électrode intérieure (12) et/ou l'électrode extérieure (14) présentant des renflements (12.1, 12.2, ..., 12.n ; 14.1, 14.2, ..., 14.n) en direction de l'autre électrode respective, de sorte que les écarts (d₃) entre les électrodes dans la zone des renflements soient inférieurs à chaque écart (d₁, d₂, d₄) entre les électrodes en-dehors de la zone des renflements, et les écarts (d₃) entre les électrodes les unes par rapport aux autres dans la zone des renflements étant essentiellement égaux,
**caractérisé en ce que** l'une des extrémités de l'électrode intérieure (12) est à l'opposé d'une surface frontale qui termine l'électrode extérieure (14), une broche munie de nervures (14.1, 14.2, ..., 14.n) et d'encoches faisant saillie de manière coaxiale dans l'intérieur de l'électrode intérieure (12) depuis la face frontale de l'électrode extérieure (14), la broche présentant une surface en section transversale de forme ondulée ou en forme d'étoile, et cette extrémité de l'électrode intérieure (12) présentant des renflements (12.1, 12.2, ..., 12.n) en direction de la broche, lesquels sont à l'opposé des nervures de la broche.

3. Générateur de micro-ondes comprenant un résonateur qui présente deux électrodes de résonateur (12, 14) espacées (d₂) l'une de l'autre, lesquelles forment un dispositif éclateur (10) à claquage lors de l'application d'une tension d'amorçage appliquée entre elles,
le dispositif éclateur (10) présentant au moins deux distances de décharge (SG1, SG2, ..., SGn) branchées en parallèle,
le résonateur présentant une structure coaxiale avec une électrode intérieure (12) essentiellement en forme d'enveloppe cylindrique et une électrode extérieure (14) qui entoure l'électrode intérieure,
l'électrode intérieure (12) et/ou l'électrode extérieure (14) présentant des renflements (12.1, 12.2, ..., 12.n ; 14.1, 14.2, ..., 14.n) en direction de l'autre électrode respective, de sorte que les écarts (d₃) entre les électrodes dans la zone des renflements soient inférieurs à chaque écart (d₁, d₂, d₄) entre les électrodes en-dehors de la zone des renflements, et les écarts (d₃) entre les électrodes les unes par rapport aux autres dans la zone des renflements étant essentiellement égaux,
**caractérisé en ce que** l'électrode extérieure (14) présente à une extrémité des renflements en forme de cames (14.1, 14.2, ..., 14.n) en direction de l'électrode intérieure (12) de forme cylindrique dépourvue de renflements.

4. Générateur de micro-ondes selon l'une des revendications 1 à 3, l'espacement (d₂) entre les électrodes de résonateur (12, 14) étant réduit à un écart (d₃) plus petit essentiellement égal dans la zone de la formation de chacune des distances de décharge (SG1, SG2, ..., SGn).

5. Générateur de micro-ondes selon la revendication 4, l'électrode intérieure (12) étant fermée à une extrémité et cette extrémité fermée de l'électrode intérieure se trouvant à l'opposé d'une surface frontale qui termine l'électrode extérieure (14), et les renflements (12.1, 12.2, ..., 12.n ; 14.1, 14.2, ..., 14.n) étant disposés dans la zone de l'extrémité fermée de l'électrode intérieure et/ou dans la zone de la surface frontale qui termine la surface extérieure.

6. Générateur de micro-ondes selon l'une des revendications 1 à 5, l'impulsion à haute tension délivrée par l'alimentation en énergie (20) étant couplée au résonateur par basse impédance.

7. Générateur de micro-ondes selon la revendication 6, l'alimentation en énergie (20) étant un générateur de Marx, un transformateur tesla, un générateur piézoélectrique ou un générateur à compression de flux, FCG, avec un commutateur à ouverture électro-explosive, EEOS.
